# DEMANDE DE BREVET EUROPEEN

(11) **EP 1 503 411 A1**
(43) Date de publication de la demande: **02.02.2005**
(21) Numéro de dépôt: 04103661.7
(22) Date de dépôt: 29.07.2004
(51) Int. Cl.: H01L 21/765, H01L 21/762, H01L 23/485, H01L 23/528

(54) **Lignes conductrices enterrées dans des zones d'isolement**

(30) Priorité: 30.07.2003 FR 0350382
(71) Demandeur: ST MICROELECTRONICS S.A., 92120 Montrouge (FR)
(72) Inventeur: SCHOELLKOPF, Jean-Pierre, 38000, GRENOBLE (FR); CERUTTI, Robin, 38100, GRENOBLE (FR); CORONEL, Philippe, 38530, BARRAUX (FR); SKOTNICKI, Thomas, 38920, CROLLES-MONFORT (FR)
(74) Mandataire: de Beaumont, Michel

(57) **Abrégé**

L'invention concerne un circuit intégré comprenant un substrat semiconducteur dans lequel des zones actives entourent ou sont entourées par des évidements remplis d'isolant, et dans lequel une région conductrice est noyée dans l'isolant d'au moins un évidement, la région conductrice étant connectée à une tension de référence et étant connectée à au moins un élément voisin du circuit.

## Description

La présente invention concerne les circuits intégrés et plus particulièrement les réseaux de distribution d'une tension de référence telle qu'une tension d'alimentation ou la masse.

Un circuit intégré comprend de façon générale un réseau de distribution de la tension d'alimentation Vdd, un réseau de distribution de la masse GND, et éventuellement des réseaux de distribution d'autres tensions de référence, par exemple Vdd/2, formés au-dessus du circuit intégré. Les lignes conductrices des réseaux de distribution font partie des lignes conductrices du réseau d'interconnexion du circuit intégré. Les lignes conductrices du réseau d'interconnexion sont formées sur plusieurs niveaux et sont reliées les unes aux autres par des vias conducteurs. Chacun de ces réseaux de distribution est généralement constitué de rails parallèles relativement longs et larges formés sur un des niveaux du réseau d'interconnexion du circuit intégré. L'espace occupé par les lignes de ces réseaux de distribution est relativement important ce qui a pour effet de limiter l'espace disponible pour les autres lignes du circuit généralement destinées à transmettre des signaux. Or la faible place disponible pour ces lignes fait qu'elles sont souvent étroites et qu'elles présentent en conséquence une résistance relativement importante qui est préjudiciable dans certains circuits tels que des mémoires.

De façon générale, la distribution de tensions de référence nécessite de prévoir des lignes conductrices formées sur les différents niveaux du réseau d'interconnexion. L'espace occupé par ces lignes conductrices de distribution peut devenir important, ce qui est préjudiciable à la réalisation de connexions destinées à transmettre des signaux.

Un moyen pour augmenter l'espace disponible pour les lignes de connexion "critiques" consiste à augmenter le nombre de niveaux du réseau d'interconnexion. Cette solution est néanmoins coûteuse. Un autre moyen consiste à diminuer la densité d'intégration de composants dans le substrat du circuit intégré afin de disposer de davantage d'espace au-dessus des composants mais cette solution va à l'encontre de l'évolution de la technologie.

Un objet de la présente invention est de prévoir une structure de lignes conductrices dédiées à la distribution d'une tension de référence qui permette d'augmenter de façon significative l'espace disponible pour la réalisation des connexions destinées à transmettre des signaux.

Un autre objet de la présente invention est de prévoir un procédé de réalisation de telles lignes conductrices dédiées à la distribution de tensions de référence.

Pour atteindre ces objets, la présente invention prévoit un circuit intégré comprenant un substrat semiconducteur dans lequel des zones actives entourent ou sont entourées par des évidements remplis d'isolant, et dans lequel une région conductrice est noyée dans l'isolant d'au moins un évidement, la région conductrice étant connectée à une tension de référence et étant connectée à au moins un élément voisin du circuit.

Selon un mode de réalisation du circuit intégré susmentionné, la région conductrice est connectée à une ligne conductrice d'alimentation ou de masse d'un réseau d'interconnexion.

Selon un mode de réalisation du circuit intégré susmentionné, ledit élément du circuit est une borne d'un composant ou une prise de polarisation du substrat ou d'un caisson formé dans le substrat.

Selon un mode de réalisation du circuit intégré susmentionné, le circuit comprend des composants formés dans des zones actives, le substrat et les composants étant recouverts d'une couche isolante de protection, une portion d'une zone active adjacente à un desdits au moins un évidement étant reliée à la région conductrice de cet évidement par l'intermédiaire d'un contact métallique placé dans une unique ouverture de la couche isolante de protection et de l'isolant recouvrant la région conductrice.

Selon un mode de réalisation du circuit intégré susmentionné, le substrat semiconducteur est en silicium monocristallin, ledit isolant étant constitué d'oxyde de silicium et de nitrure.

Selon un mode de réalisation du circuit intégré susmentionné, le circuit constitue une mémoire de type SRAM, dans laquelle le réseau de distribution des tensions d'alimentation et de masse est constitué d'un réseau de régions conductrices noyées dans plusieurs évidements du substrat, les régions conductrices étant reliées à plusieurs zones de source/drain des transistors MOS de la mémoire par des contacts.

La présente invention prévoit aussi un procédé de réalisation de lignes conductrices enterrées dans un substrat d'un circuit intégré, comprenant les étapes suivantes : former des évidements dans un substrat semiconducteur et recouvrir le fond et les parois d'isolant ; former au fond des évidements des couches d'un matériau sacrificiel ; remplir les évidements d'un isolant pour former des couches isolantes au-dessus des couches dudit matériau sacrificiel ; former des ouvertures dans les couches isolantes ; éliminer ledit matériau sacrificiel ; et remplir d'un matériau conducteur les ouvertures et l'espace précédemment occupé par ledit matériau sacrificiel.

Selon un mode de mise en oeuvre du procédé susmentionné, le procédé comprend, à la suite de la troisième étape, les étapes suivantes : former des composants dans certaines zones actives du substrat ; recouvrir le substrat et les composants d'une couche isolante de protection ; et former des ouvertures dans la couche isolante de protection et dans les couches isolantes.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue de dessus d'un exemple de portion de circuit intégré ;
la figure 2 est une vue en coupe selon la ligne AA' de la figure 1 ;
la figure 3 est une vue en coupe selon la ligne AA' de la figure 1 illustrant la présente invention ;
les figures 4 à 10 sont des vues en coupe de structures obtenues après différentes étapes du procédé de la présente invention ;
les figures 11 et 12 sont deux exemples de vues de dessus de la structure de la figure 10 ;
les figures 13 à 20 sont des vues en coupe des structures obtenues après différente étapes d'un mode particulier de mise en oeuvre du procédé de la présente invention ;
la figure 21 est un schéma d'un point mémoire de type SRAM ;
la figure 22 est une vue de dessus schématique d'un point mémoire SRAM selon la présente invention ;
la figure 23 est une vue en coupe du point mémoire de la figure 22 ;
la figure 24 est une vue de dessus schématique d'une portion externe d'une mémoire de type SRAM ; et
la figure 25 est une vue de dessus schématique d'une portion interne d'une mémoire de type SRAM.

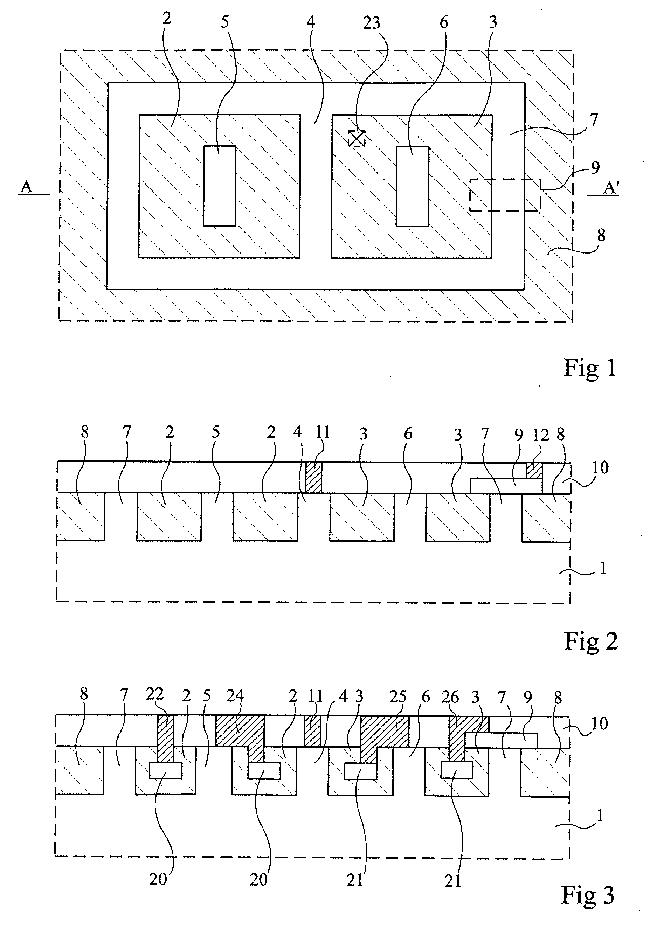

Par souci de clarté, de mêmes éléments ont été désignés par de mêmes références aux différentes figures. En outre, comme cela est courant dans la représentation des circuits intégrés, les figures 1 à 20, 22 et 23 ne sont pas tracées à l'échelle.

Les figures 1 et 2 sont respectivement une vue de dessus et en vue en coupe d'un exemple de portion d'un circuit intégré classique formé dans un substrat semiconducteur 1. Des évidements sont formés en surface du substrat 1. Ces évidements sont remplis d'un matériau isolant. Les évidements remplis d'isolant constituent des zones d'isolement couramment appelées STI, de l'anglais Shallow Trench Isolation. Les zones d'isolement sont hachurées. Les portions du substrat entourant ou entourées par des zones d'isolement constituent des zones actives. Dans cet exemple de portion de circuit, deux zones d'isolement carrées 2 et 3 sont séparées par une zone active rectangulaire 4. Deux zones actives rectangulaires 5 et 6 sont placées dans chacune des zones d'isolement 2 et 3. Les zones d'isolement 2, 3 et la zone active 4 sont entourées par une zone active sensiblement rectangulaire 7. Une zone d'isolement 8 entoure la zone active 7. A titre d'exemple, une zone de silicium polycristallin 9, représentée en pointillés sur la figure 1, est placée perpendiculairement à la portion de la zone active 7 représentée sur la droite de la figure 1. La zone 9 est séparée de la zone active 7 et des zones d'isolement 3 et 8 par une fine couche d'oxyde. La zone 9 constitue la grille d'un transistor MOS dont les source et drain sont formés dans la zone active 7 de chaque côté de la zone 9.

Divers composants non représentés sont formés dans et au-dessus des zones actives. Le substrat 1 et les zones d'isolement 2, 3 et 8 sont recouverts d'une couche isolante 10. A titre d'exemple, un contact 11 est placé dans une ouverture de la couche isolante 10 au-dessus de la zone active 4. De même, un contact 12 est placé dans une ouverture de la couche isolante 10 au-dessus de la zone de silicium polycristallin 9. Les contacts 11 et 12 permettent de relier la zone active 4 et la zone de silicium polycristallin 9 à un composant du circuit intégré ou à une borne d'alimentation par l'intermédiaire d'un réseau d'interconnexion, non représenté, placé au-dessus de la couche isolante 10.

La figure 3 est une vue en coupe d'un exemple de circuit intégré selon la présente invention dont la vue de dessus est identique à celle représentée en figure 1. La vue en coupe est réalisée comme pour la figure 2 selon l'axe AA'.

Le circuit intégré de la présente invention comprend des régions conductrices 20 et 21 noyées dans les zones d'isolement 2 et 3, et donc isolées du substrat 1. Dans cet exemple, aucune région conductrice n'est placée à l'intérieur de la zone d'isolement 8.

Un contact 22 est placé dans deux ouvertures superposées de la couche isolante 10 et de la portion de la zone d'isolement 2 au-dessus de la couche conductrice 20. De même, un contact 23, représenté par une croix dans un carré en pointillés sur la figure 1, est placé dans deux ouvertures superposées de la couche isolante 10 et de la portion de droite de la zone d'isolement 3 au-dessus de la couche conductrice 21. Les contacts 22 et 23 sont reliés au réseau d'interconnexion non représenté. Les couches conductrices 20 et 21 sont ainsi reliées chacune à une tension de référence, par exemple une tension d'alimentation et la masse, par l'intermédiaire des contacts 22 et 23.

En outre, un contact 24 est placé dans deux ouvertures superposées de la couche isolante 10 et de la portion de droite de la zone d'isolement 2. L'ouverture de la couche isolante 10 est réalisée au-dessus de la partie gauche de la zone d'isolement 2 et au-dessus de la partie droite de la zone active 5. De même, un contact 25 est placé dans deux ouvertures superposées de la couche isolante 10 et de la portion de gauche de la zone d'isolement 3. L'ouverture de la couche isolante 10 est réalisée au-dessus de la partie droite de la portion gauche de la zone d'isolement 3 et au-dessus de la partie gauche de la zone active 6. Les contacts 24 et 25 permettent ainsi de relier les couches conductrices 20 et 21 respectivement à des régions choisies des zones actives 5 et 6.

Un contact 26 est placé dans deux ouvertures superposées de la couche isolante 10 et de la portion de droite de la zone d'isolement 3. L'ouverture de la couche isolante 10 est réalisée au dessus et sur le côté de la partie de gauche de la zone de silicium polycristallin 9. Le contact 26 permet ainsi de relier la couche conductrice 21 à la zone 9 de grille du transistor.

Ainsi, un circuit intégré selon la présente invention comprend des régions conductrices placées à l'intérieur de certaines zones d'isolement entourant ou entourées par des zones actives. Les régions conductrices sont polarisées à une tension de référence et reliées à des régions choisies d'un ou plusieurs composants d'un circuit intégré par l'intermédiaire d'un contact placé au-dessus des régions conductrices.

Un avantage d'une structure de circuit intégré selon la présente invention est qu'elle permet d'intégrer un réseau de distribution de tensions de référence dans un circuit intégré sans modifier sa structure, c'est-à-dire sans augmenter le nombre de niveaux du réseau d'interconnexion et sans diminuer la densité d'intégration de composants dans le substrat.

La présente invention prévoit en outre un procédé de réalisation d'un circuit intégré comprenant comme le circuit de la figure 3 des lignes conductrices enterrées dans les zones d'isolement formées dans le substrat du circuit.

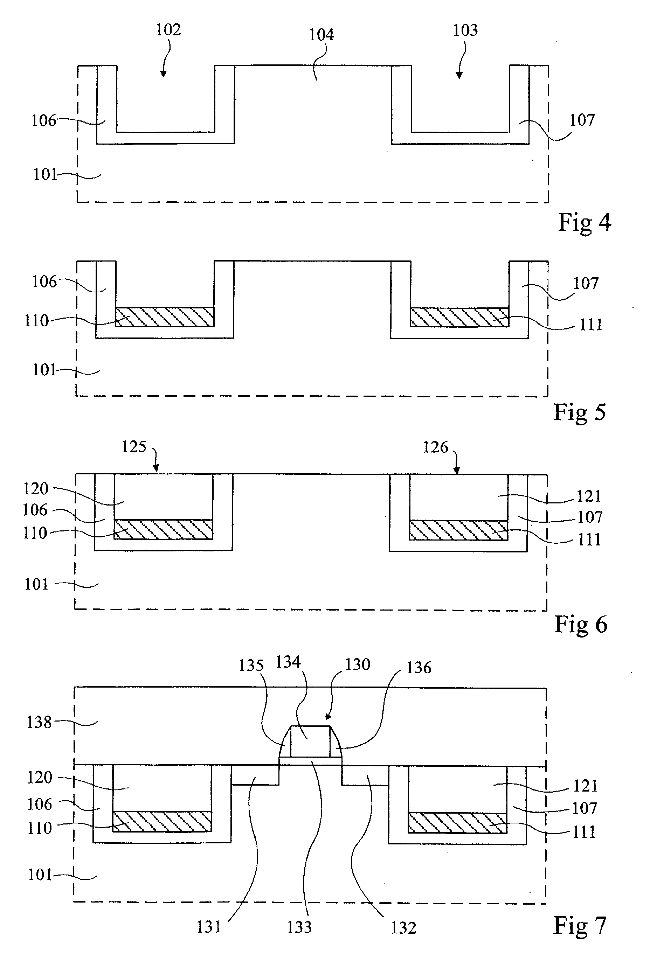

Dans une première étape, illustrée en figure 4, on forme dans un substrat 101, par exemple en silicium monocristallin, des évidements 102 et 103. Les évidements 102 et 103 sont séparés par une portion de substrat correspondant à une zone active 104. Le fond et les parois des évidements 102 et 103 sont recouverts respectivement de couches isolantes 106 et 107. Les couches isolantes 106 et 107 peuvent être constituées d'un unique isolant ou de plusieurs isolants tels que de l'oxyde de silicium (SiO₂) et du nitrure de silicium (Si₃N₄).

A l'étape suivante, illustrée en figure 5, on forme dans chacun des évidements 102 et 103 une couche sacrificielle 110, 111, constituée d'un matériau gravable sélectivement par rapport au substrat 101 et aux isolants 106 et 107. On pourra par exemple former des couches sacrificielles en silicium/germanium lorsque le substrat est en silicium. Un procédé de formation des couches 110 et 111 consiste à réaliser un dépôt de silicium/germanium sur l'ensemble de la structure de façon à remplir complètement les évidements 102 et 103, puis à polir le silicium/germanium selon un procédé standard de polissage mécano-chimique jusqu'à découvrir la surface supérieure du substrat 101, et enfin à effectuer une gravure partielle des portions de silicium/germanium remplissant les évidements 102 et 103 de façon à conserver une couche de silicium/germanium dans le fond de chacun des évidements.

A l'étape suivante, illustrée en figure 6, on forme une couche isolante dans chacun des évidements 102 et 103. Les couches intermédiaires 110 et 111 sont ainsi recouvertes respectivement de couches isolantes 120 et 121. Un procédé de formation des couches isolantes 120 et 121 consiste à effectuer un dépôt d'isolant sur l'ensemble de la structure de façon à remplir complètement les évidements 102 et 103 et à effectuer un polissage mécano-chimique de l'isolant déposé afin de découvrir la surface supérieure du substrat 101. Afin d'assurer que les évidements 102 et 103 sont bien remplis d'isolant, on pourra utiliser une technique mixte associant un dépôt et une gravure qui permet d'éviter que des "trous" ne se forment dans la couche d'oxyde de silicium quand l'évidement est profond et pas très large.

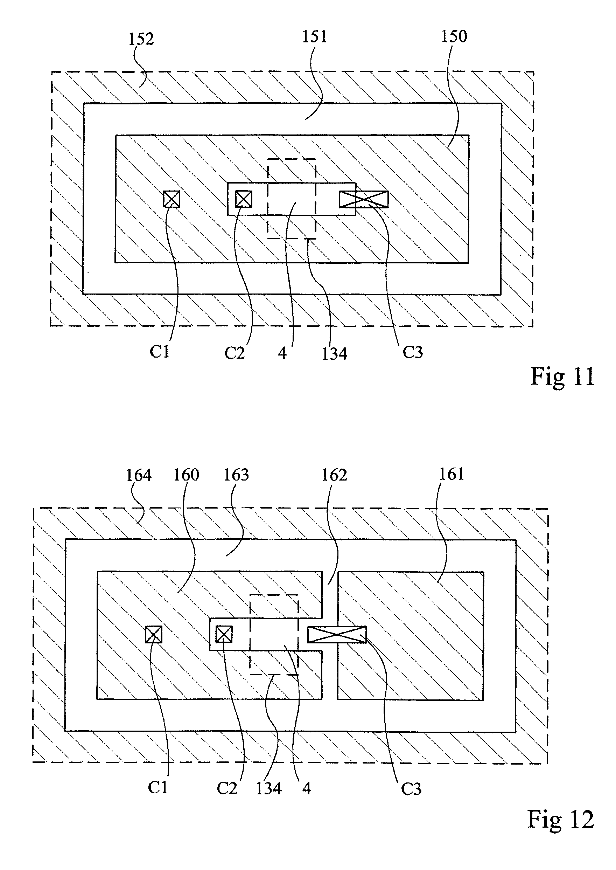

Les couches isolantes 106 et 120 appartiennent à une portion 125 d'une zone d'isolement. De même, les couches isolantes 107 et 121 appartiennent à une portion 126 d'une zone d'isolement. Les portions 125 et 126 peuvent appartenir à des zones d'isolement différentes ou à une même zone d'isolement comme cela apparaîtra dans la suite de la description en relation aux figures 11 et 12.

A l'étape suivante, illustrée en figure 7, on forme de façon classique des composants dans et au-dessus de la zone active 104. Dans cet exemple, on forme un transistor MOS 130. Des zones de source/drain 131 et 132 sont formées respectivement à proximité des zones d'isolement 125 et 126. La portion du substrat 101 placée entre les zones de source/drain 131 et 132 est recouverte d'un oxyde de grille 133 lui-même recouvert d'une grille 134. Des espaceurs isolants 135 et 136 sont formés sur les flancs de la grille 134. On recouvre ensuite l'ensemble de la structure d'une couche isolante de protection 138.

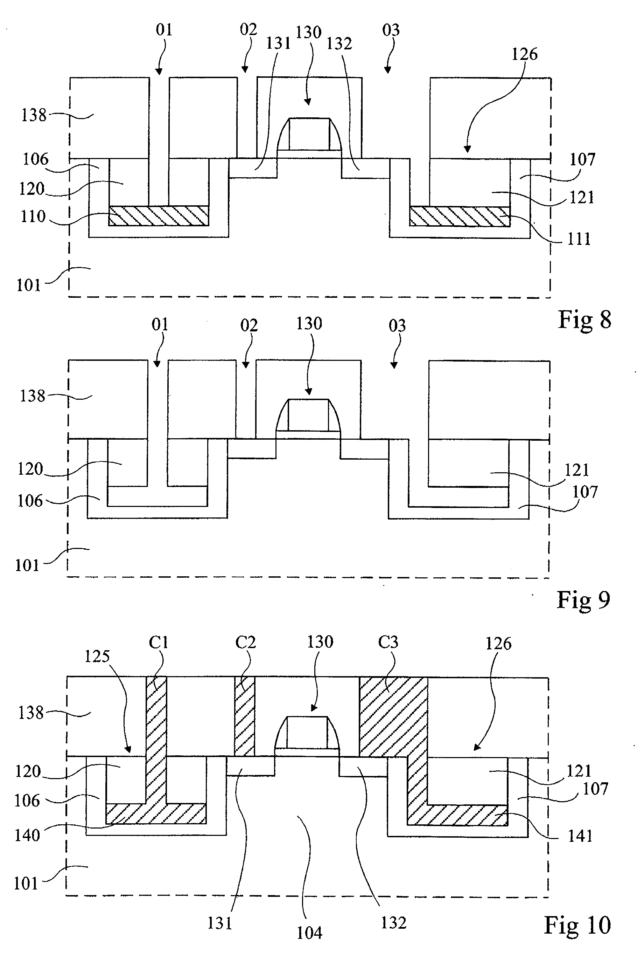

A l'étape suivante, illustrée en figure 8, on forme des ouvertures dans la couche isolante 138 et dans les couches isolantes 120 et 121, par exemple par gravure. Dans cet exemple, on forme une ouverture O1 dans les couches isolantes 138 et 120 au-dessus de la couche intermédiaire 110 de façon à découvrir une portion centrale de la couche 110. On forme une ouverture O2 dans la couche isolante 138 au-dessus de la zone de source/drain 131. On forme une ouverture O3 dans les couches isolantes 138 et 121 au-dessus de la zone de source/drain 132 et de la zone d'isolement 126 de façon à découvrir une portion de la zone de source/drain 132, la surface supérieure de la couche isolante 107 et une portion de la couche intermédiaire 111. Pour des raisons qui apparaîtront ci-après, les zones des couches isolantes 106 et 107 découvertes par cette étape de gravure doivent être constituées d'un isolant différent de celui des couches isolantes 138, 120 et 121 afin de ne pas être gravées lors de la formation des ouvertures O1, O2 et O3.

A l'étape suivante, illustrée en figure 9, on élimine les couches sacrificielles 110 et 111 par exemple par gravure. Dans le cas où les couches 110 et 111 sont en silicium/germanium et le substrat en silicium, on choisit un procédé de gravure sélectif du silicium/germanium par rapport au silicium. A l'issue de cette étape, on a formé des "tunnels" sous les couches isolantes 120 et 121.

A l'étape suivante, illustrée en figure 10, on remplit les tunnels précédemment formés et les ouvertures O1, O2 et O3 d'un matériau conducteur tel que de l'aluminium, du tungstène W ou du nitrure de titane TiN. On a ainsi formé des couches conductrices 140 et 141 à l'intérieur des zones d'isolement 125 et 126 ainsi que des contacts C1, C2 et C3 dans les ouvertures O1, O2 et O3. La couche conductrice 141 est ainsi reliée à la zone de source/drain 132 du transistor 130 par l'intermédiaire du contact C3. Comme cela a été précisé ci-dessus lors de l'étape de gravure des ouvertures O1 à O3, la portion de la couche isolante 107 placée contre la zone active 104 doit être conservée intacte afin d'éviter tout court-circuit entre la couche conductrice 141 ou le contact C3 et le substrat 101.

Le contact C1 est alors connecté, par exemple, à un potentiel de référence et le contact C3 est ensuite relié à un composant du circuit intégré formé dans le substrat 101 ou à une borne du circuit intégré par l'intermédiaire d'un réseau d'interconnexion, non représenté, qui est formé au-dessus de la couche isolante 138.

Selon une variante du procédé de la présente invention, les couches 110 et 111 déposées au fond des évidements ne sont plus des couches sacrificielles mais définitives. Les couches 110 et 111 sont alors constituées d'un matériau conducteur. Une fois les ouvertures formées au-dessus des couches conductrices, un contact métallique est directement formé dans l'ouverture. Cette variante est plus simple mais elle n'est pas conseillée dans le cas où le matériau conducteur ne peut résister aux températures élevées des étapes de réalisation des composants. En outre, le matériau ne doit pas être susceptible de diffuser dans le substrat lors de ces étapes haute température afin de ne pas endommager les composants du circuit intégré. On pourra par exemple former des couches 110 et 111 en nitrure de titane qui est un matériau stable.

Les figures 11 et 12 sont deux exemples de vues de dessus de la structure représentée en figure 10. Dans les deux figures, la zone active 4 est une petite zone rectangulaire. La grille 134, représentée en pointillés, est placée perpendiculairement à la zone active 4. Le contact C2 est placé au-dessus de la zone active 4.

La structure de la figure 11 comprend une zone d'isolement 150 rectangulaire entourant la zone active 4. Une fine zone active 151 entoure la zone d'isolement 150 qui est elle-même entourée par une zone d'isolement 152. Le contact C1 est placé au-dessus de la zone d'isolement 150 dans le prolongement de la zone active 4. Le contact C3 est placé au-dessus de la zone active 4 et de la zone d'isolement 150. Dans cet exemple de circuit, les deux portions des zones d'isolement 125 et 126 placées sous les contacts C1 et C3 appartiennent à la même zone d'isolement 150.

La structure de la figure 12 comprend deux zones d'isolement sensiblement rectangulaires 160 et 161 séparées l'une de l'autre par une fine zone active rectangulaire 162. Un des côtés de la zone active 4, où est formée la zone de source/drain 132, est accolé à la zone active 162 du côté de la zone d'isolement 160. La zone d'isolement 160 entoure ainsi partiellement la zone active 4. Les zones d'isolement 160 et 161 sont entourées par une fine zone active 163, elle-même entourée par une zone d'isolement 164. Le contact C1 est placé au-dessus de la zone d'isolement 160 dans le prolongement de la zone active 4 du côté opposé à la zone active 162. Le contact C3 est placé au-dessus de la zone active 4 et de la zone d'isolement 161. Dans cet exemple de circuit, les deux portions de la zone d'isolement 125 et 126 placées sous les contacts C1 et C3 appartiennent à des zones d'isolement différentes.

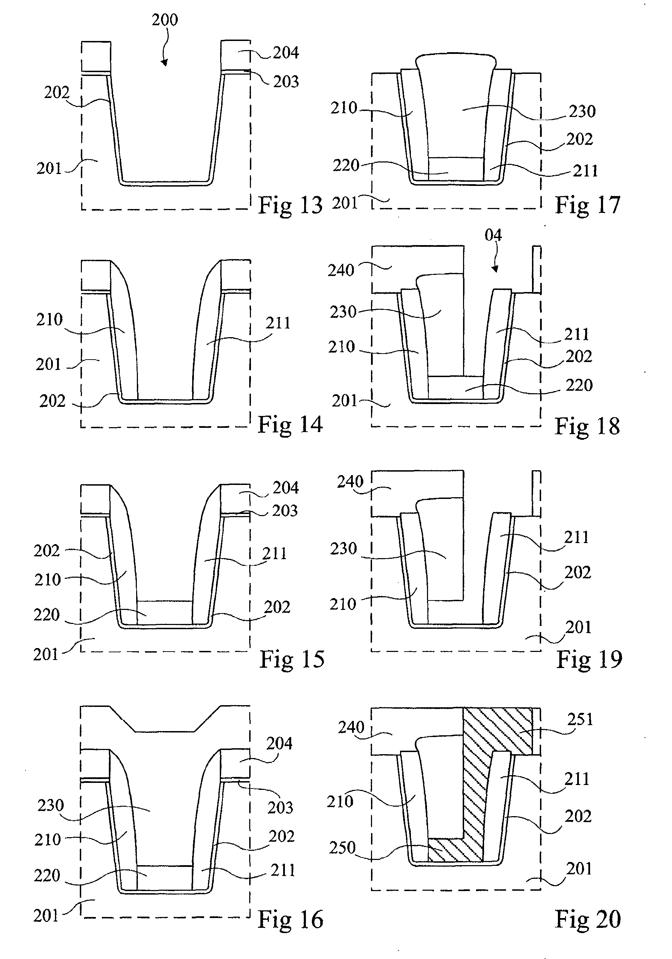

Les figures 13 à 20 sont des vues en coupe de structures obtenues après différentes étapes d'un mode de mise en oeuvre du procédé de la présente invention intégré à un procédé standard de réalisation de zones d'isolement peu profondes, plus connues sous le nom de STI de l'anglais Shallow Trench Isolation. Le procédé classique de formation de STI consiste à oxyder un substrat de silicium afin de former une fine couche d'oxyde de silicium que l'on recouvre d'une couche de nitrure puis d'une couche d'un masque constitué par exemple d'oxyde de silicium densifié (TEOS). Le masque est ensuite recouvert d'une couche de résine photosensible que l'on insole et développe afin de définir des zones où l'on souhaite réaliser un évidement du substrat. On effectue ensuite une série de gravures successivement du masque, de la couche de nitrure, de la fine couche d'oxyde de silicium et du substrat. Puis on élimine la résine et le masque. On fait croître alors une couche d'oxyde de silicium au fond et sur les parois des évidements précédemment formés dans le substrat.

La figure 13 est une vue en coupe d'une structure obtenue après l'ensemble des opérations décrites ci-dessus. Un évidement 200 est formé dans un substrat 201. Le fond et les parois de l'évidement 200 sont recouverts d'une fine couche d'oxyde de silicium 202. Sur les bords de l'évidement 200, le substrat 201 est recouvert d'une couche d'oxyde de silicium 203 elle-même recouverte d'une couche de nitrure 204.

A l'étape suivante, illustrée en figure 14, on forme des espaceurs 210 et 211 en nitrure contre les parois de l'évidement 200. Les espaceurs 210 et 211 sont par exemple formés selon un procédé classique consistant à effectuer un dépôt conforme de nitrure puis à réaliser une gravure anisotrope du nitrure de façon dans cet exemple à découvrir la fine couche d'oxyde de silicium 202 au fond de l'évidement 200.

A l'étape suivante, illustrée en figure 15, on forme une couche intermédiaire 220, en silicium/germanium dans cet exemple, au fond de l'évidement 200 selon un procédé identique à celui décrit en relation à la figure 5.

A l'étape suivante, illustrée en figure 16, on effectue un dépôt d'un isolant au-dessus de la structure de façon à remplir intégralement l'évidement 200. L'isolant déposé est classiquement de l'oxyde de silicium déposé selon une technique mixte de dépôt/gravure permettant d'éviter la formation de "trous".

A l'étape suivante, illustrée en figure 17, on réalise un polissage mécano-chimique de la couche isolante 230 jusqu'à découvrir la couche de nitrure 204. On effectue ensuite une gravure anisotrope de la couche de nitrure 204 et des espaceurs 210 et 211 jusqu'à découvrir la couche d'oxyde de silicium 203. On effectue ensuite une gravure d'oxyde de silicium jusqu'à éliminer complètement la couche d'oxyde de silicium 203. Lors de ces deux gravures, l'épaisseur de la couche isolante 230 diminue plus ou moins en fonction des procédés de gravure mis en oeuvre.

On réalise ensuite des composants dans et au-dessus de zones actives du substrat 201, non représentées, séparées les unes des autres par des évidements identiques à l'évidement 200.

A l'étape suivante, illustrée en figure 18, on recouvre l'ensemble de la structure d'une couche isolante 240. Puis on grave une ouverture 04 dans les couches isolantes 240 et 230 au-dessus d'une portion du substrat 201, de l'espaceur 211 et d'une portion de la couche intermédiaire 220.

A l'étape suivante, illustrée en figure 19, on élimine la couche intermédiaire 220 selon un procédé identique à celui décrit en relation à la figure 9.

A l'étape suivante, illustrée en figure 20, on remplit d'un matériau conducteur l'ouverture 04 ainsi que l'espace précédemment occupé par la couche 220. On a ainsi formé une couche conductrice 250 au fond de l'évidement 200 et un contact 251 dans l'ouverture 04. La couche conductrice 250 est reliée à une portion du substrat par l'intermédiaire du contact 251.

Les étapes précédemment décrites en relation aux figures 14, 15, 18, 19 et 20 s'ajoutent aux étapes du procédé standard de formation de zones d'isolement peu profondes ou STI. Ces étapes additionnelles peuvent être mises en oeuvre sur tout ou partie du circuit intégré. Si l'on souhaite former des lignes enterrées seulement dans une partie des zones d'isolement du circuit, il est nécessaire de prévoir des étapes supplémentaires de "masquage" et de "démasquage" des zones d'isolement où l'on ne souhaite pas incorporer de lignes enterrées.

Un exemple de réalisation d'un circuit intégré selon la présente invention est une mémoire de type SRAM décrite ci-après.

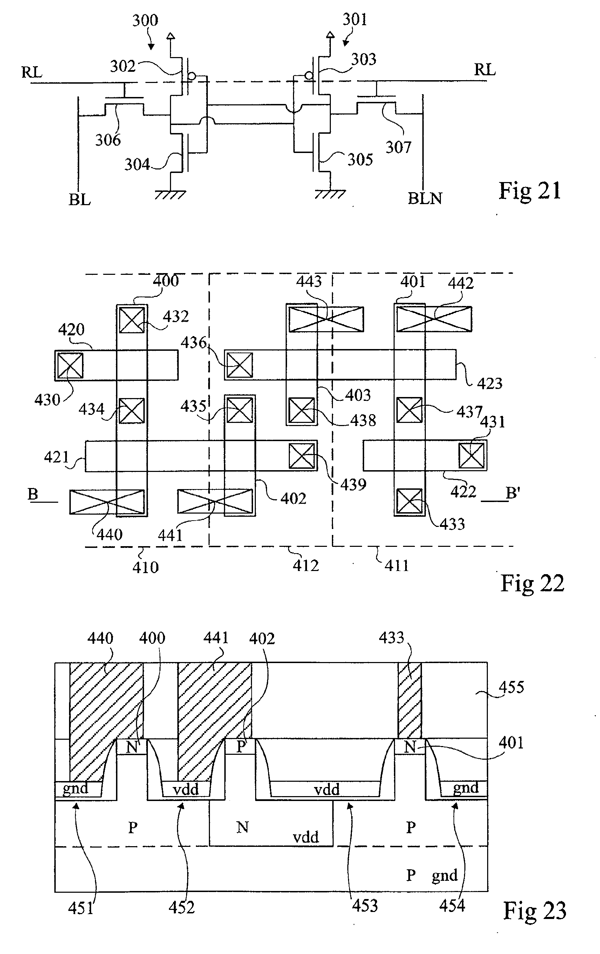

La figure 21 est un schéma classique d'un point mémoire SRAM. Le point mémoire comprend deux inverseurs 300 et 301 composés chacun d'un transistor PMOS 302 et 303 et d'un transistor NMOS 304 et 305. Les grilles des transistors 302 et 304 de l'inverseur 300 sont reliées entre elles et reliées aux drains des transistors 303 et 305 de l'inverseur 301. De même, les grilles des transistors 303 et 305 de l'inverseur 301 sont reliées entre elles et reliées aux drains des transistors 302 et 304 de l'inverseur 300. Les sources des transistors PMOS 302 et 303 sont reliées à une tension d'alimentation Vdd. Les sources des transistors NMOS 304 et 305 sont reliées à la masse GND. Les drains des transistors 302 et 304 sont reliés à une ligne de bit BL par l'intermédiaire d'un transistor NMOS 306. De même, les drains des transistors 303 et 305 sont reliés à une ligne de bit complémentaire BLN par l'intermédiaire d'un transistor NMOS 307. Les grilles des transistors 306 et 307 sont reliés à une ligne de rangée RL.

Une mémoire SRAM comprend classiquement une matrice de points mémoire tels que celui de la figure 21 que l'on peut sélectionner au moyen de plusieurs lignes de rangées et de plusieurs paires de lignes de bit BL/BLN. Le fonctionnement d'une telle mémoire SRAM est connu et ne sera pas décrit en détail.

La figure 22 est une vue de dessus schématique du point mémoire SRAM de la figure 21. Le point mémoire est formé dans un substrat de type P. Des zones actives du substrat sont représentées par des rectangles verticaux. Les grilles des transistors sont représentées par des rectangles horizontaux. Des zones d'isolement sont formées partout où ne sont pas représentées des zones actives. Les contacts sont représentés par un carré ou un rectangle dans lequel est placée une croix. De façon générale, un transistor NMOS ou PMOS est constitué d'une zone active verticale et d'une zone de grille horizontale se coupant perpendiculairement. Dans le cas d'un transistor NMOS, les portions de la zone active situées de part et d'autre de la zone de grille sont dopées de type N. Pour un transistor PMOS, les portions de la zone active situées de part et d'autre de la zone de grille sont dopées de type P.

Les zones actives correspondant aux transistors NMOS 304 et 306 constituent une unique zone active rectangulaire verticale 400 placée sur la gauche de la figure 22 à l'intérieur d'une zone de caisson P 410 représentée en pointillés. De même, les zones actives des transistors NMOS 305 et 307 constituent une unique zone active 401 de même forme que la zone 400 mais placée sur la droite de la figure 22 à l'intérieur d'une zone de caisson P 411 représentée en pointillés. Deux zones actives 402 et 403 correspondant aux transistors PMOS 302 et 303 sont placées entre les zones actives 400 et 401 à l'intérieur d'une zone de caisson N 412 représentée en pointillés. La zone active 402 correspondant au transistor PMOS 302 est placée en bas à gauche de la zone de caisson N 410 et la zone 403 correspondant au transistor PMOS 303 est placée en haut à droite de la zone de caisson N 412. Une zone de grille 420, correspondant à la grille du transistor 306, coupe la zone active 400 sur le haut de la figure. Une zone de grille 421, correspondant à la grille des transistors 302 et 304, est placée perpendiculairement aux zones actives 400 et 402 sur le bas de la figure. Une zone de grille 422, correspondant à la grille du transistor 307, coupe la zone 401 sur le bas de la figure. Une zone de grille 423, correspondant aux grilles des transistors 303 et 305, est placée perpendiculairement aux zones actives 401 et 403 sur le haut de la figure.

Deux contacts 430 et 431 sont placés respectivement sur la gauche de la zone 420 et sur la droite de la zone 422. Les contacts 430 et 431 permettent de relier les grilles des transistors 306 et 307 à la ligne de rangée RL non représentée. Deux contacts 432 et 433 placés respectivement sur le haut de la zone 400 et sur le bas de la zone 401 permettent de relier les transistors 306 et 307 aux lignes de bit respectivement BL et BLN. Trois contacts 434, 435 et 436 placés respectivement au milieu de la zone active 400, sur le haut de la zone active 402 et sur la gauche de la zone active 423, sont reliés ensemble par l'intermédiaire d'une connexion métallique non représentée. De même, trois contacts 437, 438 et 439, placés respectivement au milieu de la zone active 401, sur le bas de la zone active 403 et sur la droite de la zone active 439 sont reliés par une connexion métallique non représentée. Un contact 440 est placé au-dessus de la portion inférieure de la zone active 400 et s'étend sur la gauche au-dessus d'une zone d'isolement. Un contact 441 est placé au-dessus de la portion inférieure de la zone active 402 et s'étend sur la gauche au-dessus d'une zone d'isolement. Un contact 442 est placé au-dessus de la portion supérieure de la zone active 401 et s'étend sur la droite au-dessus d'une zone d'isolement. Un contact 443 est placé au-dessus de la portion supérieure de la zone active 403 et s'étend sur la droite au-dessus d'une zone d'isolement.

La figure 23 est une vue en coupe du point mémoire représenté en figure 23 selon un axe B-B' coupant les contacts 440, 441 et 433. Les zones actives 400, 402 et 401 sont formées en surface du substrat de type P 450. Les zones actives 400, 401 et 402 sont séparées par des portions de zones d'isolement. Une région conductrice est placée à l'intérieur de chacune des zones d'isolement. Quatre portions de zones d'isolement 451, 452, 453 et 454 sont visibles de gauche à droite. Les régions conductrices placées dans les portions 452 et 453 respectivement entre les zones actives 400 et 402 et entre les zones actives 402 et 401 sont toutes les deux reliées à une tension d'alimentation Vdd. Les régions conductrices placées dans les portions 451 et 454 respectivement placés à gauche de la zone active 400 et à droite de la zone active 401 sont toutes les deux reliées à la masse GND. Le caisson de type N 412 est placé sous la zone active 402 et sous une portion des zones d'isolement 452 et 453. Les caissons de type P 410 et 411 sont placés respectivement à gauche et à droite du caisson de type N 412. Les zones d'isolement et les zones actives sont recouvertes d'une couche isolante 455. Les contacts 440, 441 et 433 sont placés dans des ouvertures de la couche isolante 455. Le contact 440 recouvre la zone active 400, la couche isolante placée contre les parois de la zone d'isolement 451 et la région conductrice reliée à GND placée à l'intérieur de la zone d'isolement 451. La portion de la zone active 400 correspondant à la source du transistor 304 est ainsi reliée à la masse GND par l'intermédiaire du contact 440. De même, le contact 441 recouvre la zone active 402, la couche isolante placée contre les parois de la zone d'isolement 452 et la région conductrice reliée à Vdd placée au fond de la même zone 452. La portion de la zone active 402 correspondant à la source du transistor 302 est ainsi reliée à l'alimentation Vdd par l'intermédiaire du contact 441. Le contact 433 est placé de façon classique au-dessus de la portion de la zone active 401 correspondant à une zone de source/drain du transistor 307.

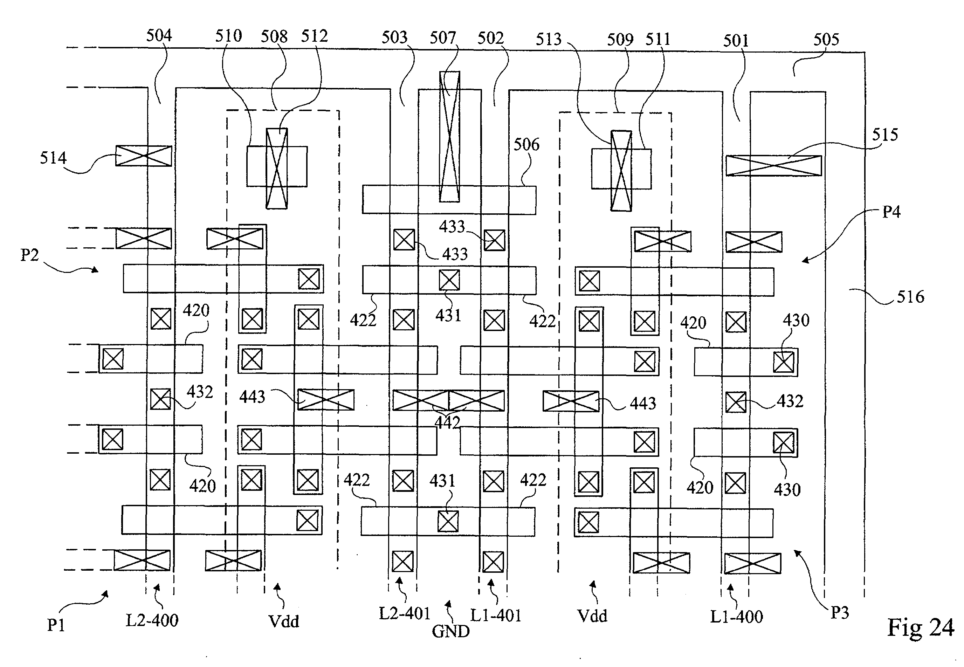

La figure 24 est une vue de dessus schématique d'une portion d'une mémoire SRAM constituée d'un ensemble de points mémoire de composition identique à celle du point mémoire décrit en relation aux figures 21 à 23. Les points mémoire sont placés les uns à côté des autres de façon à former des rangées et des colonnes de points mémoire. Dans cet exemple, quatre points mémoire P1 à P4 sont représentés. Le point P1 est représenté en bas à gauche de la figure avec une structure et une orientation identique au point mémoire représenté en figure 22. Le point P2 a une structure symétrique du point P1 par rapport à un axe horizontal. Le point P2 est placé au-dessus du point P1 de sorte que les contacts 432, 433 et 442 de chacun des points sont comme superposés et constituent en fait uniquement trois contacts. Le point P3 a une structure symétrique de celle du point P1 par rapport à un axe vertical. Le point P3 est placé à droite du point P1 de sorte que les contacts 431 de chacun des points sont superposés et constituent un même et unique contact, et de sorte que les contacts 442 sont accolés. Le point P4 a une structure symétrique de celle du point P3 par rapport à un axe horizontal. Le point P4 est placé au-dessus du point P3 de sorte que leurs contacts 432, 443 et 442 sont "superposés". De plus, le point P4 est placé à droite du point P2 de sorte que leurs contacts 431 sont "superposés" et que leurs contacts 442 sont accolés. Les paires de points P1/P2 et P3/P4 appartiennent respectivement à deux colonnes verticales différentes. Les paires de points P1/P3 et P2/P4 appartiennent à deux rangées horizontales différentes. Dans cet exemple, les points P1 à P4 appartiennent aux deux rangées supérieures de la mémoire et aux deux colonnes les plus à droite de la mémoire. Les zones actives 400 des points P3 et P4 sont accolées l'une à l'autre de façon à former une ligne active verticale continue L1-400 qui se prolonge vers le bas par des zones 400 d'autres points mémoire non représentés de la même colonne. De même, les zones 401 des points P3 et P4 sont accolées l'une à l'autre de façon à former une ligne active verticale continue L1-401 qui se prolonge vers le bas par des zones 401 d'autres points mémoire de la même colonne. De façon similaire, les zones 400 et 401 des points P3 et P4 constituent aussi des lignes actives verticales continues L2-400 et L2-401 qui se prolongent vers le bas. Les zones d'isolement situées entre les lignes actives verticales L1-400 et L1-401 constituent en fait une même et unique zone d'isolement dont la région conductrice a sensiblement la forme d'un rail relié à Vdd. De même, les zones d'isolement situées entre les lignes verticales actives L2-401 et L2-400 constituent une même et unique zone d'isolement dont la région conductrice a sensiblement la forme d'un rail relié à Vdd. Les zones d'isolement situées entre les lignes actives verticales L1-401 et L2-401 constituent une même et unique zone d'isolement dont la région conductrice a sensiblement la forme d'un rail relié à GND.

Les rails Vdd et GND se terminent en bas et en haut de chacune des colonnes de la mémoire SRAM. Deux structures "d'arrêt" sont placées en haut et en bas de la mémoire SRAM. Les deux structures sont symétriques l'une de l'autre par rapport à un axe horizontal. La structure d'arrêt supérieure est représentée en figure 24. Elle comprend quatre zones actives rectangulaires verticales 501, 502, 503 et 504 prolongeant les lignes actives verticales L1-400, L1-401, L2-401 et L2-400 vers le haut. Une zone active horizontale 505 est accolée à la partie supérieure de chacune des zones actives 501 à 504. Les rails Vdd et GND se terminent ainsi au niveau de la zone active 505. Les zones actives 501 à 505 sont dopées de type N et reliées à la masse. Afin de ne pas relier les lignes de bit BLN des points P2 et P4 à la masse, une zone de grille 506 coupe les zones actives 502 et 503 perpendiculairement au-dessus des contacts 433 des points P2 et P4. Un contact 507 est placé au-dessus de la portion de zone d'isolement délimitée verticalement par les zones actives 502 et 503 et délimitée horizontalement par la zone active 505 et la zone de grille 506. Le contact 507 s'étend au-dessus de la zone active 505 et au-dessus de la zone de grille 506. Le contact 507 relie la masse GND à la zone active 505, à la zone de grille 506 et au rail GND placé dans la portion de la zone d'isolement susmentionnée. Les transistors NMOS partageant la même zone de grille 506 sont toujours non conducteurs, ce qui isole les lignes de bit BLN de la masse.

De façon similaire, les caissons de type N 412 de chacun des points mémoire sont accolés les uns aux autres de façon à former un unique caisson vertical de type N. Les caissons de type P 410 et 411 de deux colonnes adjacentes forment un unique caisson vertical de type P. Afin de polariser correctement le caisson vertical de type N, les caissons N 412 des points P2 et P4 se prolongent vers le haut respectivement par des caissons 508 et 509. Des zones actives 510 et 511 sont placées à l'intérieur des caissons N 508 et 509. Des contacts 512 et 513 sont placés perpendiculairement aux zones actives 510 et 511. Les contacts 512 et 513 relient l'alimentation Vdd aux caissons de type N 508 et 509 ainsi qu'aux rails "Vdd". Des contacts 514 et 515 sont respectivement placés au-dessus des zones actives 504 et 501 et se prolongent au-dessus de la zone d'isolement située à gauche de la zone active 504 et au-dessus de la zone d'isolement située à droite de la zone active 501.

Afin de former un rail GND à droite de la colonne la plus à droite et à gauche de la colonne la plus à gauche de la mémoire, une ligne active verticale continue est placée de chaque côté de la mémoire. Dans cet exemple, une ligne active verticale 516 est placée à droite des contacts 430 des points P3 et P4. La partie supérieure de la ligne active verticale 516 est accolée à la zone active 505. Les régions conductrices de zones d'isolement situées entre les points mémoire et ces lignes actives verticales constituent deux rails GND. Le contact 515 se prolonge dans cet exemple jusqu'au-dessus de la ligne active 516. Le contact 515 permet de relier à la masse les zones actives 516, 501 et 505 ainsi que le rail GND placé à droite de la mémoire.

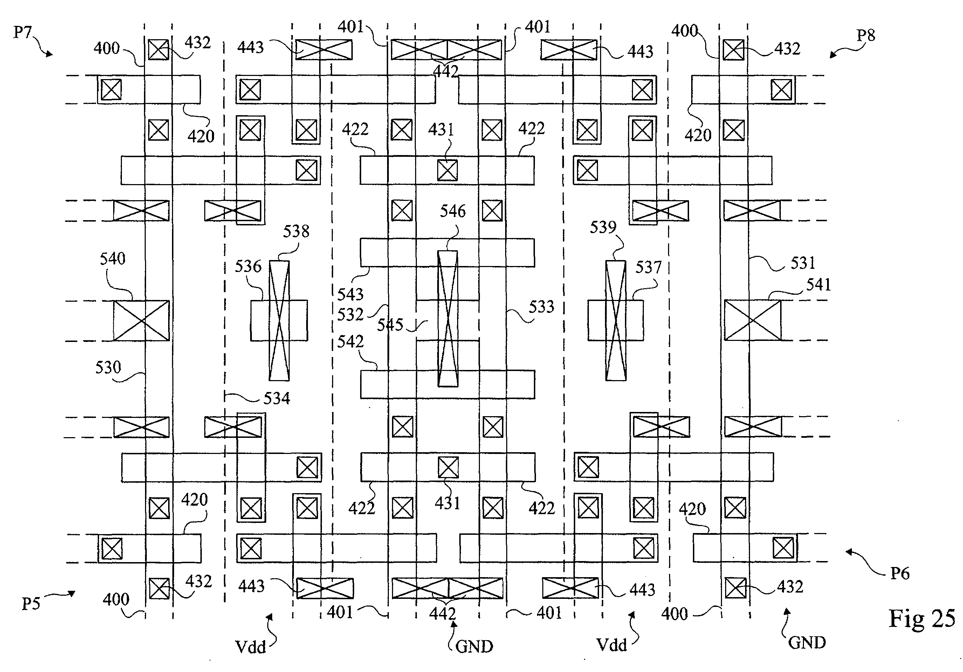

La figure 25 est une vue de dessus schématique d'une autre portion de la mémoire SRAM décrite ci-dessus. Dans le cas où la mémoire SRAM comprend un grand nombre de rangées, la longueur des rails verticaux GND et Vdd ainsi que des caissons N et P peut être importante. Il est alors nécessaire de prévoir des points d'alimentation supplémentaires de chacun des rails et des caissons en insérant par exemple des blocs de relais d'alimentation entre deux rangées de la mémoire. Deux points mémoire P5 et P6 appartenant à une même rangée sont représentés sur le bas de la figure. Le point P5 a une structure et une orientation identique à celle du point mémoire représenté en figure 22. Le point P6 a une structure symétrique de celle du point P5 par rapport à un axe vertical. Les points P5 et P6 sont accolés l'un à l'autre de sorte que leurs contacts 431 constituent un même et unique contact et que leurs contacts 442 sont accolées l'une à l'autre. De façon similaire, deux points mémoire P7 et P8 appartenant à une même rangée sont représentés sur le haut de la figure. Le point P7 a une structure symétrique de celle du point P5 par rapport à un axe horizontal. Le point P8 a une structure symétrique de celle du point P7 par rapport à un axe vertical. Les points P7 et P8 sont accolés l'un à l'autre de sorte que leurs contacts 431 constituent un même et unique contact et que leurs contacts 442 sont accolés.

Les deux rangées représentées sont reliées l'une à l'autre par un bloc relais décrit ci-après. Les zones actives 400 des points P5 et P7 sont reliées par une zone active 530. De même, les zones actives 400 des points P6 et P8 sont reliées par une zone active 531. Les zones actives 401 des points P5 et P7 sont reliées par une zone active 532. Les zones actives 401 des points P6 et P8 sont reliées par une zone active 533. Les zones actives 530, 531, 532 et 533 sont dopées de type N. Les caissons N 412 des paires de points P5/P7 et P6/P8 sont reliés respectivement par des caissons N 534 et 535. Les caissons P des points P5/P7 et P6/P8 sont reliés de façon similaire par des caissons P. Des zones actives 536 et 537 sont placées à l'intérieur des caissons N 534 et 535. Des contacts 538 et 539 sont placés perpendiculairement aux zones actives 536 et 537. Etant reliés à l'alimentation Vdd, les contacts 538 et 539 permettent d'alimenter les caissons de type N 534 et 535 ainsi que les rails Vdd placés à l'intérieur des zones d'isolement entourant les zones actives 536 et 537. Un contact 540 est placé au-dessus de la zone active 530 et se prolonge vers la gauche. Un contact 541 est placé au-dessus de la zone active 531 et se prolonge vers la droite. Etant reliés à la masse GND, les contacts 540 et 541 permettent de polariser les rails GND placés respectivement à l'intérieur des zones d'isolement situées sur la gauche des points P5/P7 et sur la droite des points P6/P8.

Afin, comme précédemment, de déconnecter les lignes de bit BLN des points P5 et P6 des lignes de bit BLN des points P7 et P8, deux zones de grille 542 et 543 sont placées perpendiculairement aux zones actives 532 et 533. Une zone active 545 est placée entre les zones de grille 542 et 543 et relie les zones actives 532 et 533. La zone active 545 est dopée de type P contrairement aux zones actives 532 et 533 qui sont dopées de type N. Un contact 546 est placé au-dessus de la zone active 545 et se prolonge au-dessus des zones d'isolement situées au-dessous et au-dessus de la zone active 545 et se prolonge au-dessus des zones de grille 542 et 543. Le contact 546 est relié à la masse. Le contact 546 permet de polariser à la masse les caissons P placés sous la zone active 545 ainsi que le rail GND placé à l'intérieur des zones d'isolement recouvertes par le contact 546. Les quatre transistors NMOS formés par les zones de grille 442, 443 et les zones actives 432 et 433 sont tous non conducteurs car leurs grilles sont à la masse.

Un avantage d'une mémoire SRAM telle que décrite précédemment est que le réseau de distribution des tensions de référence Vdd et GND est placé dans les zones d'isolement. La densité d'intégration de composants est inchangée et l'espace disponible pour les lignes de rangées et les lignes de bit est fortement augmenté.

Bien entendu, la présente invention est susceptible de diverses variantes et modifications qui apparaîtront à l'homme de l'art. En particulier, l'homme de l'art saura imaginer divers circuits intégrant un réseau de distribution selon la présente invention. En outre, les réseaux de distribution peuvent servir à véhiculer n'importe quelle tension de référence d'un circuit intégré.

## Revendications

1. Circuit intégré comprenant un substrat semiconducteur (101) dans lequel des zones actives (104) entourent ou sont entourées par des évidements remplis d'isolant, **caractérisé en ce qu'**une région conductrice (140, 141) est noyée dans l'isolant d'au moins un évidement (125, 126), la région conductrice étant connectée à une tension de référence et étant connectée à au moins un élément voisin du circuit.

2. Circuit intégré selon la revendication 1, dans lequel la région conductrice est connectée à une ligne conductrice d'alimentation ou de masse (GND, Vdd) d'un réseau d'interconnexion.

3. Circuit intégré selon la revendication 1, dans lequel ledit élément du circuit est une borne d'un composant (132) ou une prise de polarisation du substrat ou d'un caisson formé dans le substrat.

4. Circuit intégré selon la revendication 1, comprenant des composants (130) formés dans des zones actives (104), le substrat et les composants étant recouverts d'une couche isolante de protection (138), une portion d'une zone active adjacente à un desdits au moins un évidement étant reliée à la région conductrice (141) de cet évidement par l'intermédiaire d'un contact métallique (103) placé dans une unique ouverture (03) de la couche isolante de protection et de l'isolant recouvrant la région conductrice.

5. Circuit selon la revendication 1, dans lequel le substrat semiconducteur (201) est en silicium monocristallin, ledit isolant (202, 210, 211) étant constitué d'oxyde de silicium et de nitrure.

6. Circuit intégré selon la revendication 1 constituant une mémoire de type SRAM, dans lequel le réseau de distribution des tensions d'alimentation et de masse est constitué d'un réseau de régions conductrices noyées dans plusieurs évidements du substrat, les régions conductrices étant reliées à plusieurs zones de source/drain des transistors MOS de la mémoire par des contacts.

7. Procédé de réalisation de lignes conductrices enterrées dans un substrat d'un circuit intégré, comprenant les étapes suivantes :
a) former des évidements (102, 103) dans un substrat semiconducteur (101) et recouvrir le fond et les parois d'isolant (106, 107) ;
b) former au fond des évidements des couches (110, 111) d'un matériau sacrificiel ;
c) remplir les évidements d'un isolant pour former des couches isolantes (120, 121) au-dessus des couches dudit matériau sacrificiel ;
d) former des ouvertures (O1, O2, O3) dans les couches isolantes (120, 121) ;
e) éliminer ledit matériau sacrificiel ; et
f) remplir d'un matériau conducteur les ouvertures et l'espace précédemment occupé par ledit matériau sacrificiel.

8. Procédé selon la revendication 7, comprenant, à la suite de l'étape c), les étapes suivantes :
former des composants (130) dans certaines zones actives du substrat (101) ;
recouvrir le substrat et les composants d'une couche isolante de protection (138) ; et
former des ouvertures (O1, O2, O3) dans la couche isolante de protection et dans les couches isolantes.
